Europäisches Patentamt

European Patent Office

Office européen des brevets

(19)

(11) Numéro de publication: **0 140 746**

**B1**

(12) # FASCICULE DE BREVET EUROPÉEN

(45) Date de publication du fascicule du brevet:
**12.08.87**

(21) Numéro de dépôt: **84401856.4**

(22) Date de dépôt: **19.09.84**

(51) Int. Cl.⁴: **B 05 D 3/14,** H 05 B 6/78,
H 01 L 21/70

(54) **Procédé de traitement thermique, par application d'énergie microonde, de revêtements sur supports diélectriques, en particulier de revêtements électriquement conducteurs.**

(30) Priorité: **21.09.83 FR 8314989**

(43) Date de publication de la demande:
**08.05.85 Bulletin 85/19**

(45) Mention de la délivrance du brevet:
**12.08.87 Bulletin 87/33**

(84) Etats contractants désignés:
**DE GB**

(56) Documents cité:
**FR-A-1 473 832**
**FR-A-2 458 323**

(73) Titulaire: **CENTRE NATIONAL DE LA RECHERCHE SCIENTIFIQUE (CNRS), 15, Quai Anatole France, F-75007 Paris (FR)**

(72) Inventeur: **Berteaud, André- Jean, 10, Allée des Marronniers, F-91210 Draveil (FR)**
Inventeur: **Clement, René, 13, Avenue Madeleine, F-91800 Brunoy (FR)**
Inventeur: **Germain, Alain, 6-8, Avenue J.B. Fortin, F-92220 Bagneux (FR)**

(74) Mandataire: **Martin, Jean- Jacques, Cabinet REGIMBEAU 26, Avenue Kléber, F-75116 Paris (FR)**

## Description

La présente invention concerne un procédé de traitement thermique, par application d'énergie microonde, de revêtements déposés sur des supports diélectriques.

La présente invention concene en particulier un procédé de traitement thermique de revêtements contenant des charges électriquement conductrices, par application d'énergie microode.

Le procédé conforme à la présente invention est susceptible d'être mis en oeuvre tout particulièrement, mais non exclusivement, pour la réticulation d'encres thermopolymérisables contenant des charges électriquement conductrices.

On a déjà proposé de procéder à la réticulation de polymères à constituants polaires en utilisant l'énergie de microondes.

De tels procédés de traitement thermique, utilisant des microondes, offrent en particulier l'avantage de permettre des temps de traitement relativement courts, généralement de quelques minutes, avec de hauts rendements énergétiques, et avec une température moyenne de formation plus faible que celle obtenue par les processus de traitement thermique classiques.

On a décrit en particulier dans la demande de brevet FR-A-2 458 323 un procédé et un appareil pour le traitement par microondes de revêtements sur substrats.

La demande de brevet FR-A-2 458 323 précité décrit en effet un procédé de traitement thermique d'un révêtement déposé sur un support diélectrique, par application d'énergie microoonde, comprenant les étapes consistant:

i) à déposer le revêtement sur une face principale du support diélectrique, et

ii) à appliquer l'énergie microonde à l'ensemble ainsi formé de telle sorte que la direction de vibration du champ électrique soit sensiblement parallèle au revêtement.

Par ailleurs, on sait que la réticulation d'un matériau sous microondes est particulièrement efficace lorsque le matériau se présente en couche et permet alors d'élaborer des matériaux dits "filmogènes".

Cependant, il s'avère dans la pratique que les processus d'application d'énergie microonde jusqu'ici proposés sont très mal adaptés pour le traitement de certains matériaux.

Cela est en particulier le cas des revêtements contenant une forte densité de charges électriquement conductrices.

On rappellera sur ce point que l'application de microondes sur un produit présentant une conductivité élevée et une épaisseur importante ne peut généralement provoquer un échauffement de ce produit puisque précisément les propriétés de celui-ci imposent un champ électrique soit nul, soit orthogonal à la surface du produit.

Par contre, lorsque l'épaisseur du matériau conducteur est de l'ordre de grandeur de l'épaisseur de l'effet de peau (dénommée généralement profondeur de pénétration $\delta$), si la densité de charges atteint une valeur élevée, le matériau s'échauffe très vite et peut même brûler en quelques secondes pour une densité critique très élevée.

On constate notamment que des irrisations peuvent apparaître sur le matériau conducteur si la chaleur produite ne peut être évacuée assez rapidement par échange entre le support et l'air.

On rappellera que la composante tangentielle du champ électrique diminue exponentiellement dans un conducteur au voisinage de la surface de celui-ci et que l'on appelle généralement "profondeur de pénétration $\delta$" ou encore "épaisseur d'effet de peau" la profondeur où le champ électrique est affaibli dans le rapport 1/2,718 à partir d'un niveau initial quelconque correspondant à l'intensité du champ à la surface du conducteur.

Des essais ont montré en particulier qu'une destruction d'un film d'encre polymérisable chargée de carbone ou de particules métalliques, tel que cuivre ou aluminium, déposé sur un support diélectrique placé parallèlement au champ électrique pouvait être réalisée avant que la réticulation du liant polymérisable, tel que de la résine alkyde-mélamine, ne soit obtenue.

Cela est dû au fait que pour des matériaux conducteurs dont l'épaisseur est de l'ordre de grandeur de l'épaisseur de l'effet de peau, la moyenne de la composante tangentielle du champ électrique n'est pas négligeable et l'échauffement proportionnel au carré de celle-ci et à la conductivité du matériau est de ce fait élevé.

Par ailleurs une diminution de l'intensité du champ électrique appliqué au support diélectrique revêtu du produit à traiter, ou de la puissance de l'onde propagée, pour réduire l'échauffement dudit produit, ne semble pas non plus acceptable. En effet, cette solution a l'inconvénient de réduire également l'échauffement du support diélectrique ce qui n'est généralement pas souhaitable et par exemple assure une adhérence du produit à traiter sur son support diélectrique, très mauvaise, puisque le support est resté froid pendant le traitement.

Pour ces raisons, malgré les nombreux avantages susceptibles d'être obtenus grâce à l'application de microondes pour le traitement thermique de matériaux, notamment de revêtements de surface, l'on est obligé jusqu'ici de recourir à des techniques classiques de traitement pour divers matériaux, tels que par exemple les revêtements de conductivité élevée.

La présente invention vient maintenant proposer un nouveau procédé d'application d'énergie microonde à un revêtement déposé sur un support diélectrique qui permet sans détérioration du produit à traiter, par exemple une encre électriquement conductrice, d'atteindre une bonne adhérence du produit au support.

Pour cela, la demanderesse a déterminé qu'il était souhaitable de maintenir un champ électrique assez élevé sur le support, mais par contre de réduire le champ électrique appliqué sur le revêtement déposé sur le support.

Il convient cependant de noter que si le procédé conforme à la présente invention s'applique en particulier au traitement thermique de revêtements présentant une densité de charges conductrices élevée, comme cela a été précédemment évoqué, il trouve application, d'une façon générale, dans tous les cas où il est souhaitable d'intensifier l'échauffement d'un support diélectrique, par rapport à l'échauffement d'un revêtement à traiter, en comparaison des processus classiques de traitement thermique, d'un revêtement déposé sur un support diélectrique, par application d'énergie microonde.

Le procédé conforme à la présente invention comprend les étapes précitées consistant:

i) à déposer le revêtement à traiter sur une première face du support diélectrique,

ii) à appliquer une énergie microonde à l'ensemble ainsi formé, de telle sorte que la direction de vibration du champ électrique soit sensiblement parallèle au revêtement à traiter,

et est caractérisé par le fait qu'il comprend en outre l'étape consistant avant l'application de l'énergie microonde

iii) à déposer une couche d'un matériau électriquement conducteur sur une second face du support diélectrique opposée à la première et généralement parallèle à celle-ci, de telle sorte que cette couche possède une épaisseur au plus égale à dix fois la profondeur de pénétration $\delta$ de l'onde électromagnétique choisie dans ce matériau.

Les effets obtenus par l'adjonction d'une couche de matériau électriquement conducteur sur la seconde face du support diélectrique seront explicités par la suite.

Bien entendu, la présente demande de brevet couvre également les produits obtenus par la mise en oeuvre du procédé précité.

D'autres caractéristiques et avantages de la présente invention apparaîtront à la lecture de la description détaillée qui va suivre et en regard des dessins annexés donnés à titre d'exemple non limitatif sur lesquels:

- la figure 1 représente une vue en coupe d'un support diélectrique portant un revêtement à traiter sur une première face et une couche de matériau électriquement conducteur sur une seconde face, pour la mise en oeuvre du procédé conforme à la présente invention,

- la figure 2 représente une courbe illustrant la variation de la température du support diélectrique en fonction de l'épaisseur de la couche de matériau électriquement conducteur apposée sur la seconde face du support, dans un exemple de mise en oeuvre du procédé conforme à la présente invention.

La description détaillée qui va suivre concerne le traitement thermique de revêtements contenant des charges électriquement conductrices. Cependant cette description ne doit pas être considérée comme limitative, la présente invention étant susceptible d'être utilisée dans d'autres applications.

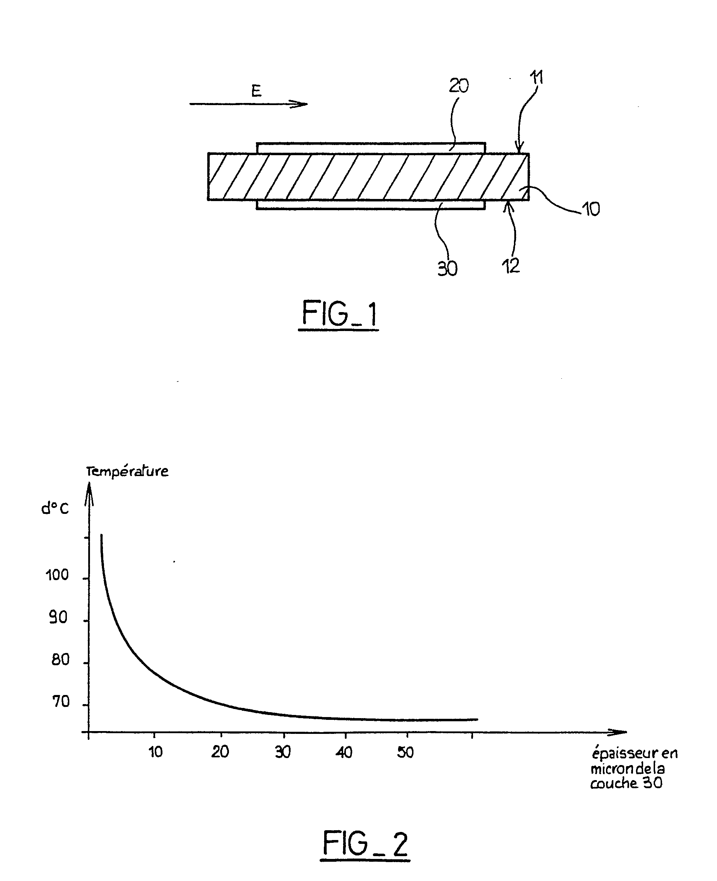

Comme cela est illustré sur la figure 1, le procédé de traitement conforme à la présente invention consiste dans un premier temps à déposer un revêtement 20 à traiter, contenant des charges électriquement conductrices, sur une première face principale 11 d'un support diélectrique 10, et à déposer une couche d'un matériau 30 électriquement conducteur sur une seconde face principale 12 du support diélectrique 10.

Plus précisément, la seconde face du support diélectrique référencée 12 est opposée à la première face 11 et généralement parallèle à celle-ci.

De préférence, les faces 11 et 12 précitées sont planes. On notera cependant que la présente invention est également susceptible de trouver application dans le cas de supports diélectriques possédant des surfaces principales incurvées dans une direction et autorisant l'application d'énergie microonde de telle sorte que la direction de vibration du champ électrique soit sensiblement parallèle aux revêtement 10 et couche 30 précités.

L'ordre des dépôts précités, du revêtement à traiter 20 sur la première face 11 d'une part, de la couche 30 de matériau électriquement conducteur sur la seconde face 12 d'autre part, importe peu. Cependant il convient de contrôler que l'épaisseur du revêtement à traiter 20 et de la couche de matériau électriquement conducteur 30 est de l'ordre de grandeur de la profondeur de pénétration de l'onde électromagnétique choisie dans ces matériaux respectifs. Cette condition a été précisée au début de la description.

Le dépôt de la couche 30 de matériau conducteur sur la seconde face du support 10 peut être réalisé selon diverses techniques.

On citera à titre d'exemples non limitatifs, pour la réalisation de cette couche 30:

- une enduction directe d'une encre électriquement conductrice,

- un dépôt métallique,

- ou encore le collage d'un film métallique.

Le dépôt de la couche 30 peut également être opéré en posant simplement la seconde face 12 du support diélectrique 10 sur un élément métallique.

La demanderesse a obtenu d'excellents résultats en plaçant le support 10 sur un berceau métallique de quelques microns d'épaisseur dont les bords ont été recourbés pour éviter l'apparition de décharges lors de l'application ultérieure de l'énergie microonde.

On peut également métalliser directement certaines parties d'un tapis de défilement et placer le support 10, recouvert de son revêtement à traiter 20, sur les parties métallisées du tapis tenant lieu de couche 30 électriquement conductrice.

L'ensemble ainsi formé constitué d'un support diélectrique 10 recouvert d'une part d'un revêtement 20 à traiter, d'autre part d'une couche 30 de matériau électriquement conducteur, est ensuite soumis à l'application d'énergie microonde.

Cette application est réalisée de telle sorte que la direction de vibration du champ électrique soit sensiblement parallèle au revêtement 20 et à la couche 30 de matériau conducteur, comme cela est représenté schématiquement par la flèche référencée E sur la fig. 1.

Pour cela, l'ensemble précité peut par exemple être déposé dans le plan de symétrie d'un guide d'onde, là où le champ électrique est maximum.

De nombreuses variantes de réalisation d'applicateurs d'énergie microonde sont susceptibles d'être utilisées pour la mise en oeuvre de la présente invention. Ces dispositions bien connues de l'homme de l'art ne seront pas décrites par la suite.

L'adjonction d'une couche de matériau électriquement conducteur sur la seconde face du support diélectrique remplit une double fonction.

D'une part, l'intensité du champ électrique est renforcée dans le plan de la seconde face (portant la couche de matériau électriquement conducteur) aux dépens de l'intensité sur la première face (portant le revêtement à traiter). De ce fait, l'échauffement du support par pertes diélectriques est accentué et la vitesse de traitement du revêtement est réduite.

D'autre part, le champ électrique intensifié appliqué sur la seconde face du support échauffe la couche de matériau électriquement conducteur, par pertes de conduction, la chaleur ainsi produite étant transmise au support diélectrique.

Afin de contrôler l'accroissement de l'échauffement du support diélectrique 10 obtenu par l'adjonction d'une couche de métallisation 30 sur la seconde face 12 du support, la demanderesse a mesuré la température atteinte, sous l'action des microondes, par un support en verre -papier- époxy, d'une épaisseur de 0,9 mm, dont la surface 12 opposée à celle recevant le revêtement à traiter 20 est posée sur une rondelle d'argent d'un diamètre de 26 mm.

Les essais ont été réalisés pour une puissance appliquée de l'orde de 1 kW et avec une fréquence de 2,45 GHz.

Plus précisément, les essais ont été réalisés avec des rondelles d'argent d'épaisseur variable, afin de contrôler l'influence de ce paramètre sur l'échauffement du support.

Les résultats obtenus sont illustrés sur la ffigure 2.

Cette figure montre clairement que la métallisation (rondelle d'argent) joue un rôle déterminant sur l'échauffement du support diélectrique tant que son épaisseur reste inférieure à 20 microns, c'est-à-dire à quelques fois la profondeur de peau δ qui est de l'ordre de 2 à 3 microns.

La composante du champ électrique tendant exponentiellement vers zéro dans l'épaisseur d'effet de peau, au-delà de l'épaisseur précitée on obtient une moyenne du champ électrique qui tend également vers zéro et de ce fait un échauffement de la couche 30 électriquement conductrice quasi nul.

En effet, l'énergie perdue dans le matériau conducteur est proportionnelle à:
$\sigma E^2$,
relation dans laquelle $\sigma$ représente la conductivité du matériau et E correspond à une valeur moyenne du champ électrique.

On notera également qu'en contrôlant l'épaisseur et la nature de la couche 30 de métallisation, on a la possibilité d'ajuster aisément et avec précision la vitesse de traitement du revêtement 20 déposée sur la première face 11 du support 10.

L'échauffement résiduel du support diélectrique 10 obtenu pour des épaisseurs de la métallisation supérieures à 30 microns est dû aux pertes diélectriques internes au support, l'échauffement de la métallisation par pertes par conduction étant négligeable.

Par ailleurs, la demanderesse a réalisé des essais de réticulation d'encres thermopolymérisables dite "conductrices" comportant des charges métalliques à l'argent déposées par sérigraphie sur la première face 11 d'un support diélectrique en verre-époxy dont la seconde face 12 était revêtue d'une couche de cuivre dont l'épaisseur variait entre 8 et 35 microns.

La vitesse de réticulation de l'encre conductrice a pu être facilement contrôlée pour que le produit soit parfaitement réticulé dans des temps de 7 à 10 mn.

Pour réaliser une réticulation des produits analogues à l'aide de fours thermiques classiques, il aurait fallu envisager un temps de traitement de l'ordre de 5 heures.

Les essais de mise en oeuvre du procédé conforme à la présente invention ont permis d'obtenir des produits constitués d'un support diélectrique revêtu d'un matériau présentant une résistance électrique de l'ordre de 50 milliohms par carré de 25 µm d'épaisseur. On rappelle, en effet, que la caractéristique de conduction électrique d'une couche conductrice ou résistive déposée par sérigraphie peut s'exprimer en ohm par carré de surface d'une couche d'épaisseur constante (par exemple de 25 µm d'épaisseur), la résistance électrique d'un tel élément carré étant proportionnelle à la résistivité du matériau, quelle que soit la surface de la couche. Cette caractéristique est classiquement utilisée par l'homme de l'art.

De tels résultats montrent que le procédé de traitement thermique, par application de microondes, de revêtements contenant des charges électriquement conductrices sur des supports diélectriques métallisés, avant traitement, à l'opposé du revêtement, est susceptible de très nombreuses applications, notamment dans l'industrie des composants électroniques composites, par exemple pour la réalisation de claviers.

D'autres essais ont été réalisés sur des revêtements à base d'encre contenant des particules de carbone présentant au repos une résistance de l'ordre de 100 ohms par carré de 25 µm d'épaisseur; les temps de réticulation sont de l'ordre de 10 à 15 minutes suivant la teneur en carbone et la puissance microonde mise en oeuvre.

On notera par ailleurs que après le traitement thermique par application d'énergie microonde, la couche de métallisation déposée sur la seconde face 12 du support peut être enlevée pour permettre éventuellement le dépôt ultérieur d'autres produits.

Avantageusement, la gamme de fréquence des microondes utilisés est comprise entre environ 0,1 GHz et environ 100 GHz, de préférence entre environ 0,5 GHz et environ 30 GHz, la profondeur de pénétration des microondes étant de quelques microns pour les métaux.

## Revendications

1. Procédé de traitement thermique d'un revêtement déposé sur un support diélectrique, par application d'énergie microonde, comprenant les étapes consistant:

i) à déposer le revêtement (20) sur une première face (11) du support diélectrique (10),

ii) à appliquer l'énergie microonde à l'ensemble ainsi formé de telle sorte que la direction de vibration du champ électrique soit sensiblement parallèle au revêtement (20),

caractérisé par le fait qu'il comprend en outre l'étape consistant avant l'application de l'énergie microonde:

iii) à déposer une couche (30) d'un matériau électriquement conducteur sur une seconde face (12) du support diélectrique (10), opposée à la première et généralement parallèle à celle-ci, de telle sorte que cette couche (30) possède une épaisseur au plus égale à dix fois la profondeur de pénétration δ de l'onde électromagnétique choisie dans ce matériau.

2. Procédé de traitement thermique selon la revendication 1, caractérisé par le fait que le revêtement (20) à traiter contient des charges électriquement conductrices.

3. Procédé de traitement thermique selon la revendication 2, caractérisé par le fait que l'épaisseur du revêtement à traiter est de l'ordre de grandeur de la profondeur de pénétration δ de l'onde électromagnétique choisie dans celui-ci.

4. Procédé de traitement thermique selon l'une des revendications 1 à 3, caractérisé par le fait que le matériau électriquement conducteur (30) déposé sous forme de couche à l'étape iii) est un métal.

5. Procédé de traitement thermique selon l'une des revendications 1 à 4, caractérisé par le fait que l'étape iii) de dépôt d'une couche de matériau électriquement conducteur (30) est réalisée par dépôt d'une encre électriquement conductrice sur la seconde face (12) du support diélectrique (10).

6. Procédé de traitement thermique selon l'une des revendications 1 à 4, caractérisé par le fait que l'étape iii) de dépôt d'une couche de matériau électriquement conducteur (30) est réalisée par dépôt métallique sur la seconde face (12) du support diélectrique (10).

7. Procédé de traitement thermique selon l'une des revendications 1 à 4, caractérisé par le fait que l'étape iii) de dépôt d'une couche de matériau électriquement conducteur (30) est réalisée par collage d'un film métallique (30) sur la seconde face (12) du support diélectrique (10).

8. Procédé de traitement thermique selon l'une des revendications 1 à 4, caractérisé par le fait que l'étape iii) de dépôt d'une couche de matériau électriquement conducteur est réalisée en posant la seconde face (12) du support diélectrique (10) contre un élément métallique (30).

9. Procédé de traitement thermique selon l'une des revendications 1 à 8, caractérisé par le fait que le revêtement (20) déposé à l'étape i) est une encre thermopolymérisable contenant des charges métalliques ou du carbone.

## Patentansprüche

1. Verfahren zur Wärmebehandlung einer Auskleidung, die auf einer dielektrischen Basis aufgebracht ist, durch Anwendung von Mikrowellenenergie, mit den folgenden Schritten:

i) Aufbringen der Auskleidung (20) auf einer ersten Seite (11) der dielektrischen Basis (10),

ii) Anwenden der Mikrowellenenergie auf das Ganze, das so geformt ist, daß die Schwingungsrichtung des elektrischen Feldes im wesentlichen Parallel zu der Auskleidung (20) ist,

dadurch gekennzeichnet, daß es außerdem einen Schritt umfaßt, vor der Anwendung der Mikrowellenenergie, bestehend aus:

iii) Aufbringen einer Schicht (30) eines elektrisch leitenden Materials auf einer zweiten Seite (12) der dielektrischen Basis (10), die der ersten gegenüber und im allgemeinen zu dieser parallel liegt, so daß diese Schicht eine Dicke besitzt, die höchstens Zehnfache der Eindringtiefe δ der gewählten elektromagnetischen Welle in dieses Material beträgt.

2. Verfahren zur Wärmebehandlung nach Anspruch 1, dadurch gekennzeichnet, daß die zu behandelnde Auskleidung (20) elektrisch leitende Ladungen besitzt.

3. Verfahren zur Wärmebehandlung nach Anspruch 2, dadurch gekennzeichnet, daß die Dicke der zu behandelnden Auskleidung von der Größenordnung der Eindringtiefe δ der gewählten elektromagnetischen Welle in diese ist.

4. Verfahren zur Wärmebehandlung nach einem der Ansprüche 1 bis 3, dadurch gekennzeichnet, daß das elektrisch leitende Material (30), das beim Schritt iii) als Schicht aufgebracht wird, ein Metall ist.

5. Verfahren zur Wärmebehandlung nach einem der Ansprüche 1 bis 4, dadurch gekennzeichnet, daß der Schritt iii) des Aufbringens einer aus elektrisch leitendem Material (30) bestehenden Schicht, durch Aufbringen einer Leitfähigkeitsfarbe auf der zweiten Seite (12) der dielektrischen Basis (10) erfolgt.

6. Verfahren zur Wärmebehandlung nach einem der Ansprüche 1 bis 4, dadurch gekennzeichnet, daß der Schritt iii) des Aufbringens einer Schicht aus elektrisch leitendem Material (30) durch metallische Ablagerung auf der zweiten Seite (12) der dielektrischen Basis (10) durchgeführt wird.

7. Verfahren zur Wärmebehandlung nach einem der Ansprüche 1 bis 4, dadurch gekennzeichnet, daß der Schritt iii) des Aufbringens einer Schicht aus elektrisch leitendem Material (30) durch Aufkleben eines Metallfilms (30) auf die zweite Seite (12) der dielektrischen Basis (10) durchgeführt wird.

8. Verfahren zur Wärmebehandlung nach einem der Ansprüche 1 bis 4, dadurch gekennzeichnet, daß der Schritt iii) des Aufbringens einer Schicht aus leitendem Material durchgeführt wird, indem die zweite Seite (12) der dielektrischen Basis (10) gegen ein metallisches Element (30) positioniert wird.

9. Verfahren zur Wärmebehandlung nach einem der Ansprüche 1 bis 8, dadurch gekennzeichnet, daß die Auskleidung (20), die beim Schritt i) aufgebracht wird, eine thermopolymerisierbare Farbe ist, die metallische Ladungen oder Carbon enthält.

**Claims**

1. A method of heat treatment of a coating deposited on a dielectric substrate, by the application of microwave energy, comprising the stages of:

i) depositing the coating (20) on a first surface (11) of the dielectric substrate (10);

ii) applying the microwave energy to the whole so formed so that the direction of vibration of the electric field is substantially parallel to the coating (20);

characterised by the fact that it comprises in addition the stage of, before the application of the microwave energy:

iii) depositing a layer (30) of an electrically conductive material on a second surface (12) of the dielectric substrate (10) opposite to the first and substantially parallel with it so that this layer (3) has a thickness at most equal to ten times the depth of penetration of the chosen electromagnetic wave into this material.

2. Method of heat treatment according to claim 1, characterised by the fact that the coating (20) to be treated contains an electrically conductive filling.

3. Method of heat treatment according to claim 2, characterised by the fact that the thickness of the coating to be treated is of the order of magnitude of the depth of penetration of the chosen electromagnetic wave into it.

4. Method of heat treatment according to one of claims 1 to 3, characterised by the fact that the electrically conductive material (30) deposited in the form of a layer in stage iii) is a metal.

5. Method of heat treatment according to one of claims 1 to 4, characterised by the fact that the stage iii) of depositing a layer of electrically conductive material (30) is effected by depositing an electrically conductive ink on the second surface (12) of the dielectric substrate (10).

6. Method of heat treatment according to one of claims 1 to 4, characterised by the fact that the stage iii) of depositing a layer of electrically conductive material (30) is effected by metallic depositing on the second surface (12) of the dielectric substrate (10).

7. Method of heat treatment according to one of claims 1 to 4, characterised by the fact that the stage iii) of depositing a layer of electrically conductive material (30) is effected by gluing a metallic film (30) onto the second surface (12) of the dielectric substrate (10).

8. Method of heat treatment according to one of claims 1 to 4, characterised by the fact that the stage iii) of depositing a layer of electrically conductive material is effected by placing the second surface (12) of the dielectric substrate (10) against a metallic element (30).

9. Method of heat treatment according to one of claims 1 to 8, characterised by the fact that the coating (20) deposited at the stage i) is a heat-polymerizable ink containing a metallic filling or carbon.

E →

20  11

10

30  12

## FIG_1

Température

d°C

100

90

80

70

10    20    30    40    50

épaisseur en
micron de la
couche 30

## FIG_2